# EUROPEAN PATENT APPLICATION

(11) **EP 4 343 842 A1**
(43) Date of publication of application: **27.03.2024**
(21) Application number: 22885550.8
(22) Date of filing: 26.09.2022
(51) Int. Cl.: H01L 25/075, H01L 33/54

(54) **PACKAGING STRUCTURE, DISPLAY SUBSTRATE AND MANUFACTURING METHOD THEREFOR, AND DISPLAY DEVICE**

(30) Priority: 27.10.2021 CN 202111254074
(71) Applicant: BOE Technology Group Co., Ltd., Chaoyang District, Beijing 100015 (CN); BOE MLED Technology Co., Ltd., Beijing 100176 (CN)
(72) Inventor: LI, Jinpeng, Beijing 100176 (CN); ZHAI, Ming, Beijing 100176 (CN); YANG, Zhifu, Beijing 100176 (CN); ZHANG, Shubai, Beijing 100176 (CN); ZHANG, Teng, Beijing 100176 (CN); LI, Jian, Beijing 100176 (CN); ZHU, Heling, Beijing 100176 (CN); QIN, Pei, Beijing 100176 (CN)
(74) Representative: Cohausz & Florack
(86) International application number: PCT/CN2022/121453
(87) International publication number: WO 2023/071663

(57) **Abstract**

The present disclosure provides a packaging structure, a display substrate and a manufacturing method therefor, and a display device. The packaging structure is used for a packaging component, and comprises: a first packaging layer which is used for coating a component; and a second packaging layer stacked with the first packaging layer, the second packaging layer being located on the side of the first packaging layer away from the component, the surface of the side of the second packaging layer facing the first packaging layer being in contact with the surface of the side of the first packaging layer facing the second packaging layer, and the surface of the side of the second packaging layer away from the first packaging layer being approximately parallel to the plane where the packaging structure is located.

## Description

### Cross References to Related Applications

The present disclosure claims the priority to Chinese Patent Application No. 202111254074.4, filed to China National Intellectual Property Administration on October 27, 2021 and entitled "ENCAPSULATING STRUCTURE, DISPLAY SUBSTRATE AND MANUFACTURING METHOD THEREFOR, AND DISPLAY APPARATUS", the entire contents of which are incorporated herein by reference.

### Technical Field

The present disclosure relates to the field of display technologies, and in particular to an encapsulating structure, a display substrate and a manufacturing method therefor, and a display apparatus.

### Background

Similar to organic light-emitting diodes (OLEDs), miniature light-emitting diodes (including Mini LEDs and Micro LEDs) are self-luminous diodes, and have a series of advantages of high brightness, ultra-low delay, and large viewing angle, etc. Since the miniature light-emitting diodes are based on metal semiconductors with a more stable property and lower resistance to achieve light emission, compared with organic light-emitting diodes based on organics to achieve light emission, the miniature light-emitting diodes have advantages of lower power consumption, better resistance to high and low temperatures, and longer service life, etc.

The miniature light-emitting diodes are used as a backlight source, which can achieve a more precise dynamic backlight effect, solve the glare phenomenon between bright and dark regions of the screen caused by the traditional dynamic backlight and optimize the visual experience while effectively improving the screen brightness and contrast. In addition, the miniature light-emitting diodes are used as a display panel, which have the advantages of self-illumination, fast response, low power consumption, high contrast, long life, and high color saturation, etc., and will become the next generation of display after the liquid crystal display and organic light-emitting display.

### Summary

Embodiments of the present disclosure provide an encapsulating structure, a display substrate and a manufacturing method therefor, and a display apparatus, which are used to solve the problem of the process edges without overflowing glue and the pressure resistance performance are not compatible in encapsulating structures in the prior art.

Therefore, embodiments of the present disclosure provide an encapsulating structure for encapsulating components, including:
a first encapsulating layer, configured to cover the components; and
a second encapsulating layer, stacked with the first encapsulating layer; and the second encapsulating layer is located at a side of the first encapsulating layer away from the components, a surface of the second encapsulating layer facing the first encapsulating layer is in contact with a surface of the first encapsulating layer facing the second encapsulating layer, and a surface of the second encapsulating layer away from the first encapsulating layer is substantially parallel to a plane where the encapsulating structure is located.

Optionally, in the above encapsulating structure provided by the embodiments of the present disclosure, the first encapsulating layer includes at least two encapsulating sub-layers stacked in a direction away from the components; in the direction away from the components, an encapsulating sub-layer closest to the components includes an ingredient with variable viscosity.

Optionally, in the above encapsulating structure provided by the embodiments of the present disclosure, in the direction away from the components, the encapsulating sub-layer closest to the components further includes a first transparent colloid, and the ingredient with variable viscosity includes an adhesive.

Optionally, in the above encapsulating structure provided by the embodiments of the present disclosure, a mass ratio of the adhesive to the first transparent colloid is greater than or equal to 1:2 and less than or equal to 2:1.

Optionally, in the above encapsulating structure provided by the embodiments of the present disclosure, in the direction away from the components, the encapsulating sub-layer closest to the components further includes a first transparent colloid, and the ingredient with variable viscosity includes expansion particles.

Optionally, in the above encapsulating structure provided by the embodiments of the present disclosure, a mass fraction of the expansion particles in the first transparent colloid is greater than or equal to 0.5% and less than or equal to 3%.

In another aspect, embodiments of the present disclosure provide a display substrate, including:
a base substrate;
a plurality of components on a side of the base substrate; and
an encapsulating structure according to the above encapsulating structure provided by the embodiments of the present disclosure, wherein the first encapsulating layer covers the plurality of components, and in a direction perpendicular to the base substrate, a thickness of the first encapsulating layer is greater than or equal to a height of the components; and the second encapsulating layer is located at a side of the first encapsulating layer away from the plurality of components, a surface of the second encapsulating layer facing the first encapsulating layer is in contact with a surface of the first encapsulating layer facing the second encapsulating layer, and a surface of the second encapsulating layer away from the first encapsulating layer is substantially parallel to the base substrate.

Optionally, in the above display substrate provided by the embodiments of the present disclosure, a hardness of the second encapsulating layer is greater than a hardness of the first encapsulating layer.

Optionally, in the above display substrate provided by the embodiments of the present disclosure, the first encapsulating layer includes a first encapsulating sub-layer and a second encapsulating sub-layer stacked.

Optionally, in the above display substrate provided by the embodiments of the present disclosure, at least one of the first encapsulating sub-layer, the second encapsulating sub-layer and the second encapsulating layer includes diffusion particles and/or carbon black particles.

Optionally, in the above display substrate provided by the embodiments of the present disclosure, the second encapsulating sub-layer is located at a side of the components away from the first encapsulating sub-layer, and the first encapsulating sub-layer includes the diffusion particles.

Optionally, in the above display substrate provided by the embodiments of the present disclosure, the second encapsulating sub-layer includes the carbon black particles.

Optionally, in the above display substrate provided by the embodiments of the present disclosure, at least part of the first encapsulating sub-layer and the second encapsulating sub-layer protrudes toward a direction away from light-emitting devices, and an orthographic projection of the protrusions on the base substrate overlaps with an orthographic projection of the light-emitting devices on the base substrate.

Optionally, in the above display substrate provided by embodiments of the present disclosure, the protrusions include first protrusions located at the first encapsulating sub-layer; and the orthographic projection of the light-emitting devices on the base substrate is located within an orthographic projection of the first protrusions on the base substrate.

Optionally, in the above display substrate provided by embodiments of the present disclosure, the protrusions include first protrusions located at the first encapsulating sub-layer, and the first protrusions surround surfaces, perpendicular to the base substrate, of the light-emitting devices, respectively.

Optionally, in the above display substrate provided by embodiments of the present disclosure, a portion of the first encapsulating sub-layer located between first protrusions adjacent to each other is substantially parallel to the base substrate.

Optionally, in the above display substrate provided by embodiments of the present disclosure, the protrusions include second protrusions located at the second encapsulating sub-layer; and
the orthographic projection of the first protrusions on the base substrate is located within an orthographic projection of the second protrusions on the base substrate, and the orthographic projection of the light-emitting devices on the base substrate is located within the orthographic projection of the second protrusions on the base substrate.

Optionally, in the above display substrate provided by embodiments of the present disclosure, a portion of the second encapsulating sub-layer located between second protrusions adjacent to each other is substantially parallel to the base substrate.

Optionally, in the above display substrate provided by embodiments of the present disclosure, the first encapsulating sub-layer includes a first transparent colloid, the second encapsulating sub-layer includes a second transparent colloid, and the second encapsulating layer includes a third transparent colloid; and
a refractive index of the first transparent colloid, a refractive index of the second transparent colloid and a refractive index of the third transparent colloid are substantially equal.

Optionally, in the above display substrate provided by embodiments of the present disclosure, the first encapsulating sub-layer includes a first transparent colloid, the second encapsulating sub-layer includes a second transparent colloid, and the second encapsulating layer includes a third transparent colloid; and
a refractive index of the second transparent colloid is different from a refractive index of the first transparent colloid, and the refractive index of the second transparent colloid is different from a refractive index of the third transparent colloid.

Optionally, in the above display substrate provided by the embodiments of the present disclosure, a color of the first encapsulating sub-layer is black, and a color of the second encapsulating sub-layer is different from the color of the first encapsulating sub-layer.

Optionally, in the above display substrate provided by the embodiments of the present disclosure, a color of the second encapsulating layer is different from the color of the first encapsulating sub-layer.

Optionally, in the above display substrate provided by the embodiments of the present disclosure, in a direction in which the light-emitting devices are away from the base substrate, a sum of a thickness of the first encapsulating sub-layer, a thickness of the second encapsulating sub-layer, and a thicknesses of the second encapsulating layer is greater than a height of the light-emitting devices.

Optionally, in the above display substrate provided by the embodiments of the present disclosure, an orthographic projection of at least one of the first encapsulating sub-layer, the second encapsulating sub-layer, and the second encapsulating layer in any direction covers an orthographic projection of the light-emitting devices.

Optionally, in the above display substrate provided by the embodiments of the present disclosure, in a direction in which light-emitting diodes are away from the base substrate, the first encapsulating sub-layer, the second encapsulating sub-layer and the second encapsulating layer are sequentially stacked;
an orthographic projection of the second encapsulating sub-layer on the base substrate completely covers an orthographic projection of the light-emitting devices on the base substrate and an orthographic projection of a gap between every two adjacent light-emitting devices on the base substrate; and
an orthographic projection of the second encapsulating sub-layer on a plane perpendicular to a surface of the base substrate facing the light-emitting devices partially covers an orthographic projection of the light-emitting devices on the plane perpendicular to the surface of the base substrate facing the light-emitting devices.

Optionally, in the above display substrate provided by the embodiments of the present disclosure, the first encapsulating sub-layer is located between every two adjacent light-emitting devices; or, an orthographic projection of the first encapsulating sub-layer on the base substrate completely covers the orthographic projection of the light-emitting devices on the base substrate and the orthographic projection of the gap between every two adjacent light-emitting devices on the base substrate; and an orthographic projection of the first encapsulating sub-layer on the plane perpendicular to the surface of the base substrate facing the light-emitting devices completely covers the orthographic projection of the light-emitting devices on the plane perpendicular to the surface of the base substrate facing the light-emitting devices.

Optionally, in the above display substrate provided by the embodiments of the present disclosure, in the direction in which the light-emitting devices are away from the base substrate, the second encapsulating sub-layer, the first encapsulating sub-layer and the second encapsulating layer are sequentially stacked;
an orthographic projection of the first encapsulating sub-layer on the base substrate completely covers an orthographic projection of the light-emitting devices on the base substrate and an orthographic projection of a gap between every two adjacent light-emitting devices on the base substrate;
an orthographic projection of the first encapsulating sub-layer on a plane perpendicular to a surface of the base substrate facing the light-emitting devices partially covers an orthographic projection of the light-emitting devices on the plane perpendicular to the surface of the base substrate facing the light-emitting devices;
an orthographic projection of the second encapsulating sub-layer on the base substrate completely covers the orthographic projection of the light-emitting devices on the base substrate and the orthographic projection of the gap between every two adjacent light-emitting devices on the base substrate; and
an orthographic projection of the second encapsulating sub-layer on the plane perpendicular to the surface of the base substrate facing the light-emitting devices completely covers the orthographic projection of the light-emitting devices on the plane perpendicular to the surface of the base substrate facing the light-emitting devices.

Optionally, in the above display substrate provided by the embodiments of the present disclosure, a surface of the second encapsulating sub-layer away from the base substrate is substantially parallel to the base substrate.

Optionally, in the above display substrate provided by the embodiments of the present disclosure, a surface of the second encapsulating sub-layer away from the base substrate at the gap between every two adjacent light-emitting devices is substantially parallel to the base substrate, and protrudes, at a region where the light-emitting devices are located, toward the direction in which the light-emitting devices are away from the base substrate.

Optionally, in the above display substrate provided by the embodiments of the present disclosure, a refractive index of the first transparent colloid, a refractive index of the second transparent colloid and a refractive index of the third transparent colloid sequentially increase, or sequentially decrease, or are alternatively set.

Optionally, in the above display substrate provided by embodiments of the present disclosure, a maximum refractive index among the refractive index of the first transparent colloid, the refractive index of the second transparent colloid and the refractive index of the third transparent colloid is greater than or equal to 1.6, and a minimum refractive index among the refractive index of the first transparent colloid, the refractive index of the second transparent colloid and the refractive index of the third transparent colloid is approximately 1.41.

Optionally, the above display substrate provided by the embodiments of the present disclosure further includes: a transparent substrate layer located at a side of a stacked layer including the first transparent colloid, the second transparent colloid and the third transparent colloid away from the base substrate; and
the refractive index of the first transparent colloid, the refractive index of the second transparent colloid, the refractive index of the third transparent colloid and a refractive index of the transparent substrate layer included in a stacked layer sequentially increase, or sequentially decrease, or are alternatively set in value.

Optionally, the above display substrate provided by the embodiments of the present disclosure further includes at least one auxiliary function layer located at a side of the transparent substrate layer away from the base substrate;
wherein the refractive index of the first transparent colloid, the refractive index of the second transparent colloid, the refractive index of the third transparent colloid, and a refractive index of the at least one auxiliary function layer sequentially increase, or sequentially decrease, or are alternatively set.

Optionally, in the above display substrate provided by the embodiments of the present disclosure, the at least one auxiliary function layer further includes: a hardened layer and an anti-fingerprint layer stacked, and the hardened layer is located between the transparent substrate layer and the anti-fingerprint layer.

Optionally, in the above display substrate provided by the embodiments of the present disclosure, the anti-fingerprint layer and/or the hardened layer include atomized particles.

Optionally, in the above display substrate provided by embodiments of the present disclosure, at least one of the second transparent colloid and the third transparent colloid is dispersed with diffusion particles.

Optionally, in the above display substrate provided by the embodiments of the present disclosure, the second transparent colloid is dispersed with diffusion particles.

Optionally, in the above display substrate provided by the embodiments of the present disclosure, a particle size of the diffusion particles is in a micron-scale, and a mass fraction of the diffusion particles in the second transparent colloid is in a range of 10%-15%.

Optionally, in the above display substrate provided by the embodiments of the present disclosure, a particle size of the diffusion particles is in a nano-scale, and a mass fraction of the diffusion particles in the second transparent colloid is in a range of 1.5%-3.5%.

Optionally, in the above display substrate provided by the embodiments of the present disclosure, the diffusion particles are transparent particles or white particles.

Optionally, in the above display substrate provided by the embodiments of the present disclosure, a material of the transparent particles includes silicon dioxide or polymethyl methacrylate, and a material of the white particles includes titanium dioxide.

Optionally, in the above display substrate provided by the embodiments of the present disclosure, the first encapsulating sub-layer is black, the second encapsulating sub-layer is white, and the second encapsulating layer is transparent.

Optionally, in the above display substrate provided by the embodiments of the present disclosure, the first encapsulating sub-layer includes carbon black particles dispersed in the first transparent colloid.

Optionally, in the above display substrate provided by the embodiments of the present disclosure, the components are light-emitting devices.

In another aspect, embodiments of the present disclosure provide a manufacturing method for the above display substrate, including:
providing a base substrate;
forming a plurality of components on the base substrate;
laminating the encapsulating structure on the plurality of components, wherein the encapsulating structure includes a first encapsulating layer and a second encapsulating layer stacked, the first encapsulating layer covers the plurality of components, and the second encapsulating layer is located at the side of the first encapsulating layer away from the plurality of components; and
hardening the second encapsulating layer to cause the surface of the second encapsulating layer away from the first encapsulating layer to be substantially parallel to the base substrate.

In another aspect, embodiments of the present disclosure provide a display apparatus, including the above display substrate provided by the embodiments of the present disclosure.

### Brief Description of Figures

FIG. 1 is a structural schematic diagram of an encapsulating structure provided by an embodiment of the present disclosure.
FIG. 2 is a correlation diagram between peeling forces and temperatures of the first encapsulating sub-layer provided by an embodiment of the present disclosure.
FIG. 3 is another structural schematic diagram of an encapsulating structure provided by an embodiment of the present disclosure.
FIG. 4 is a schematic diagram of peeling off the encapsulating structure shown in FIG. 3.
FIG. 5 is a structural schematic diagram of a display substrate provided by an embodiment of the present disclosure.
FIG. 6 is another structural schematic diagram of a display substrate provided by an embodiment of the present disclosure.
FIG. 7 is another structural schematic diagram of a display substrate provided by an embodiment of the present disclosure.
FIG. 8 is another structural schematic diagram of a display substrate provided by an embodiment of the present disclosure.
FIG. 9 is another structural schematic diagram of a display substrate provided by an embodiment of the present disclosure.
FIG. 10 is another structural schematic diagram of a display substrate provided by an embodiment of the present disclosure.
FIG. 11 is another structural schematic diagram of a display substrate provided by an embodiment of the present disclosure.
FIG. 12 is another structural schematic diagram of a display substrate provided by an embodiment of the present disclosure.
FIG. 13 is a flowchart of a manufacturing method for a display substrate provided by an embodiment of the present disclosure.

### Detailed Description

In order to make the purpose, technical solutions and advantages of the embodiments of the present disclosure clearer, the technical solutions of the embodiments of the present disclosure will be clearly and completely described below in conjunction with the drawings of the embodiments of the present disclosure. It should be noted that the size and shape of each figure in the drawings do not reflect the true scale, but are only intended to illustrate the present disclosure. And the same or similar reference numerals represent the same or similar elements or elements having the same or similar functions throughout.

Unless otherwise defined, the technical terms or scientific terms used herein shall have the usual meanings understood by those having ordinary skill in the art to which the present disclosure belongs. "First", "second" and similar words used in the present disclosure and claims do not indicate any order, quantity or importance, but are only used to distinguish different components. "Comprising" or "containing" and similar words mean that the elements or items appearing before the words include the elements or items listed after the words and their equivalents, without excluding other elements or items. "Inner", "outer", "upper", "lower" and so on are only used to indicate the relative positional relationship, and when the absolute position of the described object changes, the relative positional relationship may also change accordingly.

Existing methods for encapsulating miniature light-emitting diodes include three schemes, i.e., molding, pressing a hard film and laminating a soft film, but these three schemes all have their limitations on the process. Among them, in the molding encapsulating process, the glue needs to be coated on the miniature light-emitting diode substrate, and the fluidity of the glue is good, so it will generate glue-overflow process edges. In the scheme of pressing the hard film, the hard film is a double-layer structure including a black hard film and a transparent hard film. Usually, the black hard film is heat-treated to become a molten state and then pressed on the miniature light-emitting diode substrate. Due to the black hard film of the molten state has a certain degree of fluidity, so it will generate glue-overflow process edges. In the scheme of laminating the soft film, the soft film includes multiple layers of soft plastic, which can be directly laminated on the miniature light-emitting diode substrate. Because the soft plastic has low fluidity, no glue-overflow process edges will be generated, but the pressure resistance performance of the soft film is poor.

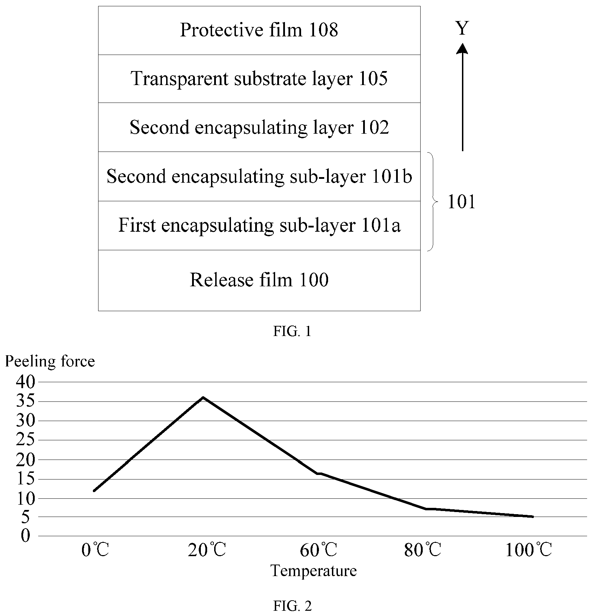

In order to solve the above-mentioned problems existing in related art, embodiments of the present disclosure provide an encapsulating structure for encapsulating components E, as shown in FIG. 1, the encapsulating structure includes:
a first encapsulating layer 101, configured to cover the components E; in order to fit and cover the components E better, the first encapsulating layer 101 may have flexibility; and
a second encapsulating layer 102, stacked with the first encapsulating layer 101. The second encapsulating layer 102 is located at a side of the first encapsulating layer 101 away from the components E, and a surface of the second encapsulating layer 102 facing the first encapsulating layer 101 is in contact with a surface of the first encapsulating layer 101 facing the second encapsulating layer 102, and a surface of the second encapsulating layer 102 away from the first encapsulating layer 101 is substantially parallel to a plane where the encapsulating structure is located. The relationship of "substantially parallel" in the disclosure may be exactly parallel, or may have some deviation (e.g., an included angle is in a range of 0°-5°) due to the influence of factors such as manufacturing process and measurement, etc. Optionally, before the encapsulating structure encapsulates the components E, the first encapsulating layer 101 and the second encapsulating layer 102 may both be film layers parallel to the plane where the encapsulating structure is located; after the encapsulating structure encapsulates the components E, the first encapsulation may protrude at the position of the components E, so that the surface of the first encapsulating layer 101 away from the components E is an uneven surface, and correspondingly, the surface of the second encapsulating layer 102 in contact with the first encapsulating layer 101 is also an uneven surface. In order to improve the pressure resistance performance of the encapsulating structure, a hardening treatment can be performed on the second encapsulating layer 102 after encapsulating is completed, and after the hardening treatment, the surface of the second encapsulating layer 102 away from the first encapsulating layer 101 is required to have better flatness to cause the second encapsulating layer 102 substantially to be parallel to the plane where the encapsulating structure is located, so as to ensure that the effect of uniform light-emitting can be achieved when the components E are light-emitting devices. Based on this, the hardness of the second encapsulating layer 102 in the present disclosure is adjustable. In other words, the second encapsulating layer 102 can be flexible before the encapsulation and can be rigid after the encapsulation. Optionally, the hardness of the second encapsulating layer 102 can be changed through treatment methods such as light irradiation or heating, etc., so that the second encapsulating layer 102 has rigidity.

In the above-mentioned encapsulating structure provided by the embodiments of the present disclosure, the first encapsulating layer 101 is used to directly cover the components E, which will not generate glue-overflow process edges. In addition, the hardness of the second encapsulating layer 102 is adjustable, so that the pressure resistance performance of the encapsulating structure can be ensured to be better by increasing the hardness of the second encapsulating layer 102.

In some embodiments, in the above-mentioned encapsulating structure provided by the embodiments of the present disclosure, as shown in FIG. 1, the first encapsulating layer 101 may include at least two encapsulating sub-layers (e.g., the first encapsulating sub-layer 101a and the second encapsulating sub-layer 101b) stacked in a direction Y away from the components E. In the direction Y away from the components E, the encapsulating sub-layer (e.g., the first encapsulating sub-layer 101a) closest to the components E includes an ingredient with variable viscosity, and under a certain condition, the viscosity of the ingredient can be changed. For example, the ingredient is an ingredient with thermosetting, hot melt, room temperature curing, pressure-sensitive, etc., so that the encapsulating sub-layer (e.g., the first encapsulating sub-layer 101a) closest to the components E is adjustable.

The encapsulating sub-layer (e.g., the first encapsulating sub-layer 101a) closest to the components E directly covers the components E. In the case that the viscosity of the encapsulating sub-layer is adjustable, once the encapsulation is found to be poor, the entire encapsulating structure may be easily peeled off by reducing the viscosity of the encapsulating sub-layer without damaging the components E, thereby realizing the reworking for the components E and improving the product yield.

In some embodiments, in the above-mentioned encapsulating structure provided by the embodiments of the present disclosure, in the direction Y away from the components E, the encapsulating sub-layer (e.g., the first encapsulating sub-layer 101a) closest to the components E may further include a first transparent colloid, the above-mentioned ingredient with variable viscosity may include an adhesive. Optionally, the viscosity of the adhesive may be related to the temperature or other factors. In some embodiments, as shown in FIG. 2, the viscosity of the adhesive is temperature dependent. In a temperature range of 0°C to 20°C, as the temperature increases, the peeling force required for peeling off increases gradually (which is equivalent to that the viscosity of the adhesive gradually increases). In a temperature range of 20°C to 80°C, as the temperature increases, the peeling force required for peeling off decreases gradually (which is equivalent to that the viscosity of the adhesive gradually decreases), and the peeling force decreases faster in the temperature range of 20°C to 60°C than in the temperature range of 60°C to 80°C. In a temperature range of 80°C to 100°C, as the temperature increases, the peeling force required for peeling off decreases gradually (which is equivalent to that the viscosity of the adhesive gradually decreases), and the peeling force values in this temperature range are all small, which can achieve the technical effect of peeling off the encapsulating structure without damaging the components E. Considering that high temperature may affect the performance of components E, in the actual production line operation, 80°C to 90°C can be selected for the viscosity reduction.

In some embodiments, in the above encapsulating structure provided by the embodiments of the present disclosure, a mass ratio of the adhesive to the first transparent colloid may be greater than or equal to 1:2 and less than or equal to 2:1, e.g., 1:1. Within this ratio range and under the normal use environment (e.g., a room temperature), the encapsulating sub-layer (e.g., the first encapsulating sub-layer 101a) including the adhesive and the first transparent colloid can have good viscosity to ensure the lamination effect. Moreover, when heated to a certain temperature (e.g., 80° C to 90° C), the viscosity of the encapsulating sub-layer (e.g., the first encapsulating sub-layer 101a) including the adhesive and the first transparent colloid can be greatly reduced, so that it can be easily peeled off from the components E without glue residue and components E falling off when the encapsulating sub-layer needs to be peeled off.

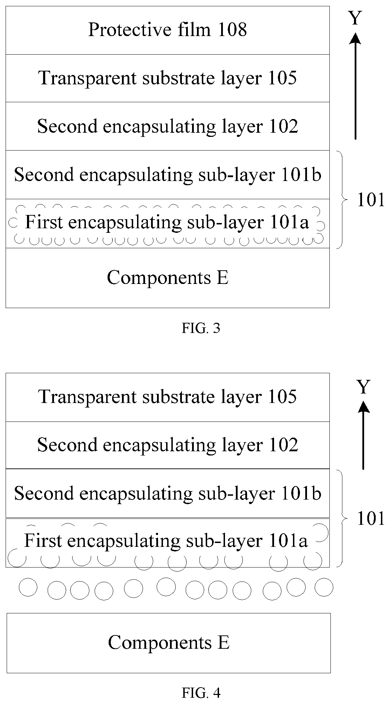

In some embodiments, in the above encapsulating structure provided by the embodiments of the present disclosure, as shown in FIG. 3, in the direction Y away from the components E, the encapsulating sub-layer (e.g., the first encapsulating sub-layer 101a) closest to the components E may further include a first transparent colloid, and the above-mentioned ingredient with variable viscosity may include expansion particles. The expansion particle is granular, and its material can be macromolecule material, e.g., a resin. Under a certain condition (e.g. a high temperature), a volume of the expansion particles increases rapidly, causing at least part of the expansion particles to expand beyond the first transparent colloid, and due to the expansion particles themselves are non-adhesive, so after expansion, the encapsulating structure can be separated from the components E (as shown in FIG. 4), so as to achieve the effect of rework.

In some embodiments, in the above-mentioned encapsulating structure provided by the embodiments of the present disclosure, a mass fraction of the expansion particles in the first transparent colloid may be greater than or equal to 0.5% and less than or equal to 3%, e.g., 1.5%. Within this ratio range and under the normal use environment (e.g., the room temperature), the encapsulating sub-layer (e.g., the first encapsulating sub-layer 101a) including the expansion particles and the first transparent colloid can have good viscosity to ensure the lamination effect. The volume of the expansion particles can be increased by heating, so that the encapsulating structure can be peeled off from the components E without glue residue and components E falling off.

Based on the same inventive concept, an embodiment of the present disclosure provides a display substrate, including the above encapsulating structure provided by the embodiments of the present disclosure. Since the problem-solving principle about the display substrate is similar to that of the above-mentioned encapsulating structure, the implementation of the display substrate can refer to the embodiments of the above-mentioned encapsulating structure, which will not be repeated herein.

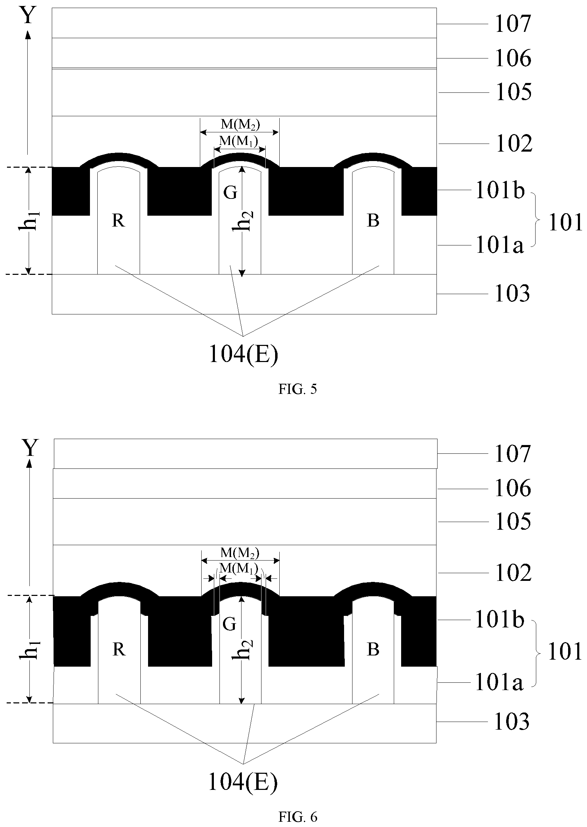

Specifically, the display substrate provided by the embodiments of the present disclosure, as shown in FIG. 5, includes:
a base substrate 103, which may be a printed circuit board (PCB) or a glass substrate (Glass);
a plurality of components E arranged at a side of the base substrate 103; and
an encapsulating structure, which is the above-mentioned encapsulating structure provided by the embodiments of the present disclosure. The first encapsulating layer 101 covers a plurality of components E, and in a direction perpendicular to the base substrate 103 (which is equivalent to a direction Y away from the components E), a thickness h₁ of the first encapsulating layer 101 is greater than or equal to a height h₂ of the components E. The second encapsulating layer 102 is arranged on a side of the first encapsulating layer 101 away from the plurality of components E, and a surface of the second encapsulating layer 102 facing the first encapsulating layer 102 is in contact with a surface of the first encapsulating layer 101 facing the second encapsulating layer 102. The surface of the second encapsulating layer 102 away from the first encapsulating layer 101 is substantially parallel to the base substrate 101. A hardness of the second encapsulating layer 102 is greater than a hardness of the first encapsulating layer 101. In some embodiments, the hardness of the second encapsulating layer 102 may be greater than or equal to 4H (Rockwell hardness), and the first encapsulating layer 101 may be a soft plastic layer with flexibility.

The thickness h₁ of the first encapsulating layer 101 that is soft is greater than or equal to the height h₂ of the components E, so that the components E can be completely wrapped by the first encapsulating layer 101, thereby avoiding the damage to the components E by the second encapsulating layer 102 with higher hardness.

In some embodiments, in the above-mentioned display substrate provided by the embodiments of the present disclosure, as shown in FIG. 5, the first encapsulating layer 101 may include a first encapsulating sub-layer 101a and a second encapsulating sub-layer 101b stacked. Optionally, the second encapsulating sub-layer 101b is located on a side of the components E away from the first encapsulating sub-layer 101a. At least one of the first encapsulating sub-layer 101a, the second encapsulating sub-layer 101b, and the second encapsulating layer 102 may include diffusion particles and/or carbon black particles. When the components E are light-emitting devices 104, the diffusion particles can cause the light emitted by the light-emitting devices 104 to scatter on the diffusion particles, thereby improving the uniformity of light-emitting in all directions and effectively improving the color shift. When the light-emitting devices 104 do not emit light, the carbon black particles can absorb the ambient light irradiated inside the display substrate, thereby reducing the brightness of the black state and improving the contrast.

It should be noted that, in the present disclosure, "the first encapsulating layer covers the components" may mean that the first encapsulating layer is in direct contact with each side surface of the components, or the first encapsulating layer is in direct contact with each side surface and the top surface of the components.

In some embodiments, in the above display substrate provided by the embodiments of the present disclosure, as shown in FIG. 5, the first encapsulating sub-layer 101a includes diffusion particles. Since the first encapsulating sub-layer 101a directly covers the light-emitting devices 104, the light emitted by the light-emitting devices 104 is directly scattered on the diffusion particles in the first encapsulating sub-layer 101a, which can obtain a better effect of light mixing and is beneficial to improve the color shift.

In some embodiments, the particle size of the diffusion particles may be in the micron-scale or nano-scale. Considering that the diffusion particles can affect the light transmittance to a certain extent while diffusing the light, the concentration of the diffusion particles needs to be set reasonably. Optionally, on the basis of taking into account both the light mixing and transmittance, a mass fraction (i.e., concentration) of the micron-scale diffusion particles in the first transparent colloid can be set to be in a range of 10%-15%. The nano-scale diffusion particles have a greater impact on the transmittance, therefore, a mass fraction of nano-scale diffusion particles in the first transparent colloid can be smaller than the mass fraction of micron-scale diffusion particles in the first transparent colloid. For example, the mass fraction of the nano-scale diffusion particles in the first transparent colloid is set to be in a range of 1.5%-3.5%.

In some embodiments, the diffusion particles can be transparent particles or white particles. It should be understood that, when the diffusion particles are the transparent particles, the first encapsulating sub-layer 101a with the diffusion particles is colorless and transparent, and when the diffusion particles are the white particles, the first encapsulating sub-layer 101a with the diffusion particles is white. The first encapsulating sub-layer 101a in a transparent or white state can have better transmittance, which is beneficial to improve light efficiency.

In some embodiments, the material of the transparent particles may include silicon dioxide (SiO₂) or polymethyl methacrylate (PMMA), and the material of the white particles may include titanium dioxide (TiO₂). Certainly, in the specific implementation, the materials of the transparent particles and the white particles may also be other materials known to those skilled in the art, and are not specifically limited herein.

In some embodiments, in the above display substrate provided by the embodiments of the present disclosure, as shown in FIG. 5, the second encapsulating sub-layer 101b includes carbon black particles. It can be seen from FIG. 5 that the second encapsulating sub-layer 101b including the carbon black particles is located above the first encapsulating sub-layer 101a including diffusion particles, so when the light-emitting devices 104 does not emit light, the second encapsulating sub-layer 101b can effectively absorb the ambient light which is prevented from irradiating on the diffusion particles in the lower first encapsulating sub-layer 101a and being scattered, thereby significantly improving the contrast. Certainly, in some embodiments, carbon black particles may also be doped in the second encapsulating layer 102 to improve the contrast, which is not specifically limited herein.

Considering that when the light-emitting devices 104 are in a light-emitting state, the carbon black particles can absorb the light emitted by the light-emitting devices 104 to a certain extent, resulting in a slight loss of brightness in the white state. Therefore, in order to take into account the brightness of the black state and the light-emitting efficiency, in the present disclosure, the mass percentage (also referred to as concentration) of the carbon black particles doped in the second transparent colloid can be in a range of 2% to 4%, preferably 3%.

In some embodiments, the first encapsulating sub-layer 101a appears white because it is doped with the diffusion particles (such as white particles). The second encapsulating sub-layer 101b appears black because it is doped with the carbon black particles. The second encapsulating layer 102 appears transparent because it is not doped with the diffusion particles and carbon black particles.

In some embodiments, the light-emitting devices 104 may be miniature light-emitting diodes, e.g., Mini LEDs or Micro LEDs. Since a size of Mini LED is in a range of 100 µm to 200 µm, and a size of Micro LED is below 100 µm, resolutions of Mini LED and Micro LED products can be higher, and display screens of the Mini LED and Micro LED products are more delicate. In addition, a major advantage of Mini LEDs and Micro LEDs is that they can be spliced, that is, multiple small-sized products can be spliced together to realize large-sized products.

In some embodiments, in the above-mentioned display substrate provided by the embodiments of the present disclosure, as shown in FIG. 5, after the encapsulating structure is laminated on the display substrate, the first encapsulating sub-layer 101a and the second encapsulating sub-layer 101b are lifted up by the light-emitting devices 104 at the positions of the light-emitting devices 104 due to the presence of the light-emitting devices 104, so at least part of the first encapsulating sub-layer 101a and the second encapsulating sub-layer 101b protrudes toward a direction (i.e., Y direction in FIG. 5) away from the light-emitting devices 101 to form protrusions M. An orthographic projection of the protrusions M on the base substrate 103 overlaps with an orthographic projection of the light-emitting devices 104 on the base substrate 103. It should be understood that when the first encapsulating sub-layer 101a is relatively thin, it may also occur that the first encapsulating sub-layer 101a is pierced by the light-emitting device(s) 104, so that the first encapsulating sub-layer 101a has an opening(s) formed at the top of the light-emitting device(s) 104, as shown in FIG. 6.

In some embodiments, as shown in FIG. 5, a protrusion M may include a first protrusion M1 located at the first encapsulating sub-layer 101a. The orthographic projection of the light-emitting device 104 on the base substrate 103 is located within an orthographic projection of the first protrusion M1 on the base substrate 103. In this case, the first encapsulating sub-layer 101a is not pierced by the light-emitting device 104. Alternatively, as shown in FIG. 6, the first protrusion M1 surrounds a surface of the light-emitting device 104 perpendicular to the base substrate 103 (i.e., a side surface of the light-emitting device 104). In this case, the first encapsulating sub-layer 101a is pierced by the light-emitting device 104, so that the first encapsulating sub-layer 101a has an opening formed at the top of the light-emitting device 104. Optionally, as shown in FIGS. 5 and 6, a portion of the first encapsulating sub-layer 101a located between first protrusions M1 that are adjacent to each other is substantially parallel to the base substrate 103. That is, the portion of the first encapsulating sub-layer 101a located between the adjacent first protrusions M1 is exactly parallel to the base substrate 103, and may have some deviation (e.g., the included angle is in the range of 0°-5°) due to the influence of factors such as manufacturing process and measurement, etc.

In some embodiments, as shown in FIGS. 5 and 6, the protrusion M may further include a second protrusion M2 located at the second encapsulating sub-layer 101b. The orthographic projection of the first protrusion M1 on the base substrate 103 is located within an orthographic projection of the second protrusion M2 on the base substrate 103. The orthographic projection of the light-emitting device 104 on the base substrate 103 is located within the orthographic projection of the second protrusion M2 on the base substrate 103. Optionally, as shown in FIGS. 5 and 6, a portion of the second encapsulating sub-layer 101b located between second protrusions M2 that are adjacent to each other is substantially parallel to the base substrate 103. That is, the portion of the second encapsulating sub-layer 101b located between the adjacent second protrusions M2 is exactly parallel to the base substrate 103, and may have some deviation (e.g., the included angle is in the range of 0°-5°) due to the influence of factors such as manufacturing process and measurement, etc.

It should be noted that in the present disclosure, the thickness h₁ of the first encapsulating layer 101 refers to a thickness before lamination, which may be equivalent to a thickness of the first encapsulating layer 101 with better flatness at the gap between the light-emitting devices 104 after lamination, and is not a thickness of the first encapsulating layer 101 that is lifted up at the position of the light-emitting device 104.

In some embodiments, in the above display substrate provided by the embodiments of the present disclosure, the first encapsulating sub-layer 101a includes a first transparent colloid, the second encapsulating sub-layer 101b includes a second transparent colloid, and the second encapsulating layer 102 includes a third transparent colloid. A refractive index of the first transparent colloid, a refractive index of the second transparent colloid and a refractive index of the third transparent colloid can be substantially equal, or exactly equal, i.e., the difference between refractive indices which is zero. There may also be an error caused by the measurement or process, e.g., the difference between refractive indices is less than 0.1. The first transparent colloid, the second transparent colloid, and the third transparent colloid with the same refractive index are used, which avoids the requirement to adjust different colloid parameters when making different encapsulating layers, and saves costs.

In some embodiments, in the above display substrate provided by the embodiments of the present disclosure, the refractive index of the second transparent colloid may be different from the refractive index of the first transparent colloid, and the refractive index of the second transparent colloid is different from the refractive index of the third transparent colloid. That is, the refractive indices of two layers of transparent colloids which are adjacent to each other are different. Multiple layers of transparent colloids with different refractive indices can make the light emitted by the light-emitting devices 104 be refracted at an interface between the two adjacent layers of transparent colloids, which changes a propagation direction of the light, so that the refracted light is relatively divergent to achieve the effect of light mixing, reduce the chromatic aberration at the large viewing angle, and greatly improve the picture quality.

In some embodiments, in the above-mentioned display substrate provided by the embodiments of the present disclosure, in the case that the refractive index of the first transparent colloid contained in the first encapsulating sub-layer 101a is different from the refractive index of the second transparent colloid contained in the second encapsulating sub-layer 101b, a color of the first encapsulating sub-layer 101a may be black, and a color of the second encapsulating sub-layer 101b may be different from the color of the first encapsulating sub-layer 101a. By arranging the first encapsulating sub-layer 101a and the second encapsulating sub-layer 101b with different refractive indices on the light-emitting side of the plurality of light-emitting devices 104, the light emitted by the light-emitting devices 104 can be refracted at an interface between the first encapsulating sub-layer 101a and the second encapsulating sub-layer 101b, which changes the propagation direction of the emitted light, so that the refracted light is relatively divergent to achieve the effect of light mixing, reduce the chromatic aberration at the large viewing angle, and thus effectively solving the problem of the color shift at the large viewing angle and greatly improving the picture quality . At the same time, the black first encapsulating sub-layer 101a can effectively absorb ambient light and reduce the brightness of the black state. Since part of the light emitted by the light-emitting devices 104 can be absorbed by black to a certain extent, in the disclosure, by arranging the second encapsulating sub-layer 101b with the color different from the black, it can be ensured that the second encapsulating sub-layer 101b cooperating with the first encapsulating sub-layer 101a improves the color shift while reducing the absorption for the light emitted by the light-emitting devices 104 as much as possible and effectively improving the light-emitting efficiency, so as to improve the display brightness. Combining the above two factors the contrast and appearance quality of the product can be significantly improved.

In some embodiments, the black first encapsulating sub-layer 101a can be obtained by doping the melanin, e.g., carbon black particles, etc., in the first transparent colloid. Optionally, in order to take into account both the brightness of the black state and the light-emitting efficiency, the mass percentage (also referred to as concentration) of the carbon black particles doped in the first transparent colloid in the present disclosure can be in the range of 2% to 4%, preferably 3%.

In some embodiments, in the above display substrate provided by the embodiments of the present disclosure, the refractive index of the third transparent colloid contained in the second encapsulating layer 102, the refractive index of the first transparent colloid contained in the first encapsulating sub-layer 101a, and the refractive index of the second transparent colloid contained in the second encapsulating sub-layer 101b are different, and the color of the second encapsulating layer 102 is different from the color of the first encapsulating sub-layer 101a. The arrangement of the first encapsulating sub-layer 101a, the second encapsulating sub-layer 101b, and the second encapsulating layer 102 can make the light emitted by the light-emitting devices 104 be refracted at the interface between any two adjacent encapsulating layers, which further changes the propagation direction of the emitted light, so that the divergence of the refracted light is greater and a better effect of light mixing is achieved, and thus effectively solving the problem of the color shift at the large viewing angle and greatly improving the picture quality.

It should be noted that, in the disclosure, the problem of improving the color shift is illustrated by only taking the first encapsulating sub-layer 101a, the second encapsulating sub-layer 101b, and the second encapsulating layer 102 which are arranged as three light dimming layers as an example. Certainly, in the specific implementation, more light dimming layers can be provided to improve the color shift, as long as the refractive indices of the transparent colloids contained in two adjacent light dimming layers are different. Moreover, in the specific implementation, the respective light dimming layers can be fabricated in respective stages above the light-emitting devices 104; or the light dimming layers can also be fabricated as a stacked composite film layer, and then the composite film layer can be directly laminated with a side of the display substrate with the light-emitting devices 104.

In some embodiments, in the above-mentioned display substrate provided by the embodiments of the present disclosure, as shown in FIGS. 5 to 10, the first encapsulating sub-layer 101a, the second encapsulating sub-layer 101b and the second encapsulating layer 102 may be arranged at the side of the light-emitting devices 104 away from the base substrate 103 and at the gaps among the light-emitting devices 104, so that the light emitted from the upper surface and the side surface of the light-emitting device 104 is refracted at the interface between two adjacent encapsulating layers with different refractive indices, and thereby improving the divergence of the light emitted from the upper surfaces and the side surfaces of the light-emitting devices 104 at the same time to better solve the problem of color shift. Moreover, in this case, light-emitting devices 104 are completely wrapped by the first encapsulating sub-layer 101a, the second encapsulating sub-layer 101b and the second encapsulating layer 102, so that the first encapsulating sub-layer 101a, the second encapsulating sub-layer 101b and the second encapsulating layer 102 can encapsulate and protect the light-emitting devices 104, which is beneficial to extend the service life of light-emitting devices 104.

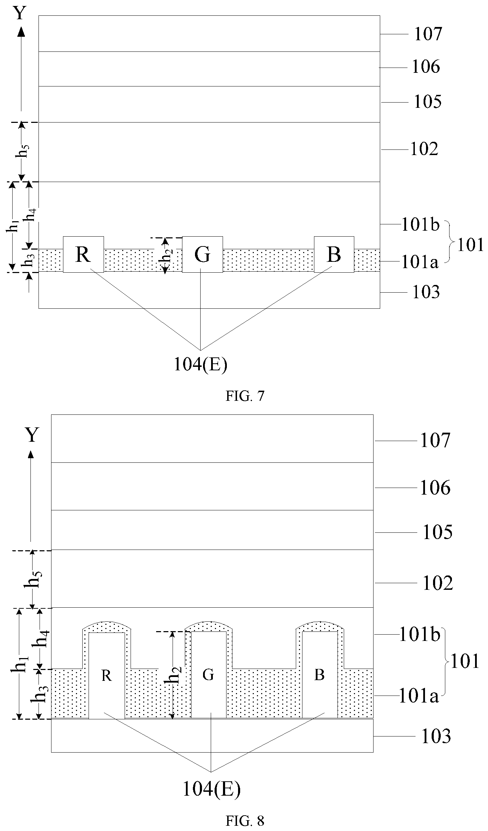

In some embodiments, in the above-mentioned display substrate provided by the embodiments of the present disclosure, as shown in FIGS. 7 to 10, in the direction Y where the light-emitting devices 104 is away from the base substrate 103, a sum of a thickness h₃ of the first encapsulating sub-layer 101a, a thickness h₄ of the second encapsulating sub-layer 101b and a thickness h₅ of the second encapsulating layer 102 (i.e., h₃+h₄+h₅) is greater than the height h₂ of the light-emitting devices 104, so that the product appearance is better. Moreover, as can be seen from FIGS. 7 to 10, a surface of a stacked layer composed of the first encapsulating sub-layer 101a, the second encapsulating sub-layer 101b and the second encapsulating layer 102 away from the base substrate 103 is relatively flat, which is beneficial to make subsequent film layers.

It should be noted that the thickness of the encapsulating layer and the thickness of the encapsulating sub-layer in the present disclosure both refer to a coating thickness. Due to the existence of the light-emitting devices 104, the thickness of the encapsulating layer or the encapsulating sub-layer in the region where the light-emitting devices 104 are located, and the thickness of the encapsulating layer or the encapsulating sub-layer at the gap(s) between the light-emitting devices 104 may be different, and the thickness uniformity in the region where the light-emitting devices 104 located are poor. Therefore, the above coating thickness may be substantially equal to the thickness of the encapsulating layer or the encapsulating sub-layer at the gap(s) between the light-emitting devices 104 in an actual product.

Optionally, the height h₂ of the light-emitting device(s) 104 is about 85 µm, the sum of the thickness h₃ of the first encapsulating sub-layer 101a, the thickness h₄ of the second encapsulating sub-layer 101b, and the thickness h₅ of the second encapsulating layer 102 (i.e., h₃+h₄ +h₅) may be at least 50 µm-100 µm larger than the height h₂ of the light-emitting device(s) 104. In some embodiments, the thickness h₃ of the first encapsulating sub-layer 101a may be in the range of 25 µm to 50 µm, so that, the first encapsulating sub-layer 101a can be used to effectively improve the contrast while maintaining a high transmittance of the first encapsulating sub-layer 101a. The thickness h₄ of the second encapsulating sub-layer 101b and the thickness h₅ of the second encapsulating layer 102 can be 50 µm to 100 µm, so that the film layer yield of the second encapsulating sub-layer 101b and the second encapsulating layer 102 made through the coating process is relatively high. Certainly, in the specific implementation, the values of h₃, h₄, h₅, and h₄ may be adjusted appropriately according to actual conditions, which will not be limited herein.

In some embodiments, in the above-mentioned display substrate provided by the embodiments of the present disclosure, in order to improve the color shift and effectively encapsulating the light-emitting devices 104, as shown in FIGS. 7 to 10, an orthographic projection of at least one of the first encapsulating layer 101a, the second encapsulating sub-layer 101b and the second encapsulating layer 102 in any direction covers the orthographic projection of the light-emitting devices 104. In other words, at least one of the first encapsulating sub-layer 101a, the second encapsulating sub-layer 101b and the second encapsulating layer 102 can partially or completely wrap the light-emitting devices 104.

Exemplarily, as shown in FIG. 7, one of the first encapsulating sub-layer 101a, the second encapsulating sub-layer 101b, and the second encapsulating layer 102 is located between every two adjacent light-emitting devices 104, in which case the film layer(s) (e.g., the first encapsulating sub-layer 101a shown in FIG. 7) located between the light-emitting devices 104 can be made by coating. Continuing to refer to FIG. 7, in the direction Y in which the light-emitting devices 104 is away from the base substrate 103, the first encapsulating sub-layer 101a, the second encapsulating sub-layer 101b and the second encapsulating layer 102 are sequentially stacked. The first encapsulating sub-layer 101a is arranged between every two adjacent light-emitting devices 104. An orthographic projection of the second encapsulating sub-layer 101b on the base substrate 103 completely covers the orthographic projection of the plurality of light-emitting devices 104 on the base substrate 103 and the orthographic projection of the gap between every two adjacent light-emitting devices 104 on the base substrate 103. An orthographic projection of the second encapsulating sub-layer 101b on a plane perpendicular to a surface (i.e., the upper surface of the base substrate 103) of the base substrate 103 facing the light-emitting devices 104 (i.e., two planes, one of which is perpendicular to the paper and the other of which is parallel to the paper) partially covers an orthographic projection of the light-emitting devices 104 on the plane perpendicular to the surface of the base substrate 103 facing the light-emitting devices 104. In this case, the first encapsulating sub-layer 101a is partially in contact with the side surface of the light-emitting devices 104, and the second encapsulating sub-layer 101b is in full contact with the upper surfaces of the light-emitting devices 104 and is in contact with the remaining surfaces of the light-emitting devices 104 that are not in contact with the first encapsulating sub-layer 101a. That is, the second encapsulating sub-layer 101b wraps the upper surfaces of the light-emitting devices 104 and part of the side surfaces of the light-emitting devices 104 adjacent to the upper surfaces. It can be seen from FIG. 7 that the thickness h₃ of the first encapsulating sub-layer 101a made by the coating is smaller than the height h₂ of the light-emitting device(s) 104, and the sum of the thickness h₃ of the first encapsulating sub-layer 101a and the thickness h₄ of the second encapsulating sub-layer 101b (that is, the thickness h₁ of the first encapsulating layer 101) is greater than the height h₄ of the light-emitting device(s) 104, so that the upper surface of the second encapsulating sub-layer 101b is substantially parallel to the base substrate 103.

As shown in FIG. 8, in the direction Y in which the light-emitting devices 104 are away from the base substrate 103, the first encapsulating sub-layer 101a, the second encapsulating sub-layer 101b, and the second encapsulating layer 102 are sequentially stacked. The orthographic projection of the first encapsulating sub-layer 101a on the base substrate 103 completely covers the orthographic projection of the plurality of light-emitting devices 104 on the base substrate 103 and the orthographic projection of the gap between every two adjacent light-emitting devices 104 on the base substrate 103. The orthographic projection of the first encapsulating sub-layer 101a on the plane perpendicular to the surface of the base substrate 103 facing the light-emitting devices 104 completely covers the orthographic projection of the light-emitting devices 104 on the plane perpendicular to the surface of the base substrate 103 facing the light-emitting devices 104. The orthographic projection of the second encapsulating sub-layer 101b on the base substrate 103 completely covers the orthographic projection of the plurality of light-emitting devices 104 on the base substrate 103 and the orthographic projection of the gap between every two adjacent light-emitting devices 104 on the base substrate 103. The orthographic projection of the second encapsulating sub-layer 101b on the plane perpendicular to the surface of the base substrate 103 facing the light-emitting devices 104 partially covers the orthographic projection of the light-emitting devices 104 on the plane perpendicular to the surface of the base substrate 103 facing the light-emitting devices 104. In this case, the first encapsulating sub-layer 101a is in complete contact with the upper surfaces and side surfaces of the light-emitting devices 104, realizing all-round wrapping for the light-emitting devices 104. The second encapsulating sub-layer 101b is separated from the upper surfaces and side surfaces of the light-emitting devices 104 by the first encapsulating sub-layer 101a. It can be seen from FIG. 8 that the thickness h₃ of the first encapsulating sub-layer 101a is smaller than the height h₂ of the light-emitting devices 104, and the first encapsulating sub-layer 101a has protrusions at the top of the light-emitting devices 104, which is caused by the film lamination. Certainly, in some embodiments, the first encapsulating sub-layer 101a may also be pierced by the light-emitting devices 104 during the film lamination, so that the first encapsulating sub-layer 101a has openings formed at the top of the light-emitting devices 104. In addition, as shown in FIG. 8, the sum of the thickness h₃ of the first encapsulating sub-layer 101a and the thickness h₄ of the second encapsulating sub-layer 101b (i.e., the thickness h₁ of the first encapsulating layer 101) is greater than the height h₂ of the light-emitting devices 104, so that the upper surface of the second encapsulating sub-layer 101b is substantially parallel to the base substrate 103.

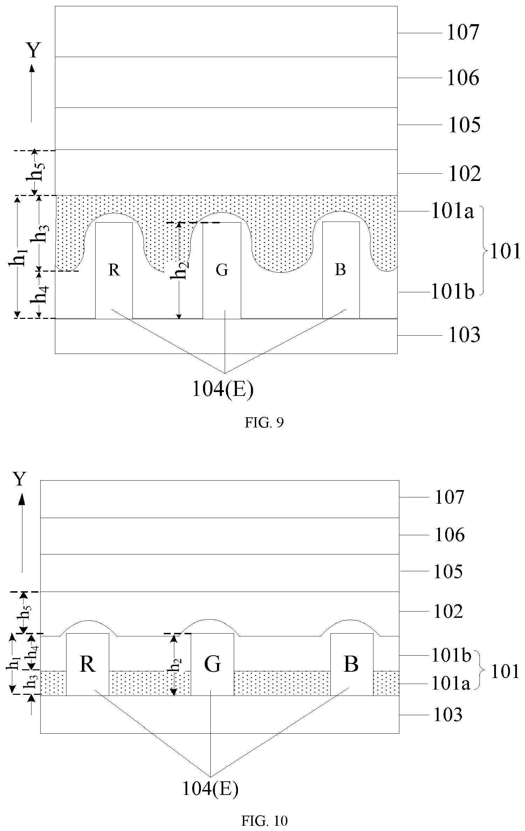

As shown in FIG. 9, in the direction Y in which the light-emitting devices 104 are away from the base substrate 103, the second encapsulating sub-layer 101b, the first encapsulating sub-layer 101a and the second encapsulating layer 102 are sequentially stacked. The orthographic projection of the first encapsulating sub-layer 101a on the base substrate 103 completely covers the orthographic projection of the plurality of light-emitting devices 104 on the base substrate 103 and the orthographic projection of the gap between every two adjacent light-emitting devices 104 on the base substrate 103. The orthographic projection of the first encapsulating sub-layer 101a on the plane perpendicular to the surface of the base substrate 103 facing the light-emitting devices 104 partially covers the orthographic projection of the light-emitting devices 104 on the plane perpendicular to the surface of the base substrate 103 facing the light-emitting devices 104. The orthographic projection of the second encapsulating sub-layer 101b on the base substrate 103 completely covers the orthographic projection of the plurality of light-emitting devices 104 on the base substrate 103 and the orthographic projection of the gap between every two adjacent light-emitting devices 104 on the base substrate 103. The orthographic projection of the second encapsulating sub-layer 101b on the plane perpendicular to the surface of the base substrate 103 facing the light-emitting devices 104 completely covers the orthographic projection of the light-emitting devices 104 on the plane perpendicular to the surface of the base substrate 103 facing the light-emitting devices 104. In this case, the second encapsulating sub-layer 101b is in complete contact with the upper surfaces and the side surfaces of the light-emitting devices 104, realizing all-round wrapping for the light-emitting devices 104 is. The first encapsulating sub-layer 101a is separated from the upper surfaces and the side surfaces of the light-emitting devices 104 by the second encapsulating sub-layer 101b. It can be seen from FIG. 9 that the thickness h₄ of the second encapsulating sub-layer 101b is smaller than the height h₂ of the light-emitting devices 104, and the first encapsulating sub-layer 101a has protrusions at the top of the light-emitting devices 104 and depressions at the gaps among the light-emitting devices 104, and correspondingly, the first encapsulating sub-layer 101a also has protrusions at the top of the light-emitting devices 104 and depressions at the gaps among the light-emitting devices 104, which are caused by the film lamination. Certainly, in some embodiments, the second encapsulating sub-layer 101b may also be pierced by the light-emitting devices 104 during the film lamination, so that the second encapsulating sub-layer 101b has openings formed at the top of the light-emitting devices 104. In addition, as shown in FIG. 9, the sum of the thickness h₃ of the first encapsulating sub-layer 101a and the thickness h₄ of the second encapsulating sub-layer 101b (i.e., the thickness h₁ of the first encapsulating layer 101) is greater than the height h₂ of the light-emitting devices 104, so that the upper surface of the first encapsulating sub-layer 101a is substantially parallel to the base substrate 103.

It can be known from the above that, in the above display substrate provided by the embodiments of the present disclosure, the second encapsulating sub-layer 101b can directly or indirectly wrap each light-emitting device 104. Therefore, when the upper surface of the second encapsulating sub-layer 101b is far from the top of the light-emitting devices 104, as shown in FIGS. 7 and 8, the surface (i.e., the upper surface) of the second encapsulating sub-layer 101b away from the base substrate 103 may be substantially parallel to the base substrate 103. When the upper surface of the second encapsulating sub-layer 101b is close to the top of the light-emitting devices 104, as shown in FIG. 10, the surface (i.e., the upper surface) of the second encapsulating sub-layer 101b away from the base substrate 103 at the gap between two adjacent light-emitting devices 104 may be substantially parallel to the base substrate 103, and protrude at the top position of each light-emitting device 104 toward the direction Y away from the light-emitting devices 104. Alternatively, as shown in FIG. 9, the surface (i.e., the upper surface) of the second encapsulating sub-layer 101b away from the base substrate 103 may protrude at the top position of each light-emitting device 104 toward the direction Y away from the light-emitting devices 104 and recess at the gap between every two adjacent light-emitting devices 104 toward the base substrate 103.

In addition, it can be seen from FIGS. 7 and 8 that the surface (i.e., the upper surface) of the second encapsulating sub-layer 101b away from the base substrate 103 is higher than the upper surfaces of the light-emitting devices 104. It can be seen from FIG. 9, at the gap between every two light-emitting devices 104, the surface (i.e., the upper surface) of the second encapsulating sub-layer 101b away from the base substrate 103 is lower than the upper surfaces of the light-emitting devices 104. It can be seen from FIG. 10, at the gap between every two light-emitting devices 104, the surface (i.e., the upper surface) of the second encapsulating sub-layer 101b away from the base substrate 103 may be flush with the upper surfaces of the light-emitting devices 104.

In some embodiments, in the above display substrate provided by the embodiments of the present disclosure, the refractive index of the first transparent colloid, the refractive index of the second transparent colloid, and the refractive index of the third transparent colloid can sequentially increase, or sequentially decrease, or be alternatively set. Exemplarily, when the refractive index of the first transparent colloid, the refractive index of the second transparent colloid and the refractive index of the third transparent colloid are sequentially increase (i.e., from low to high), the refractive index of the first transparent colloid can be 1.41, the refractive index of the second transparent colloid can be 1.54, and the refractive index of the third transparent colloid can be 1.6. When the refractive index of the first transparent colloid, the refractive index of the second transparent colloid and the refractive index of the third transparent colloid are sequentially decrease (i.e., from high to low), the refractive index of the first transparent colloid can be 1.6, the refractive index of the second transparent colloid can be 1.54, and the refractive index of the third transparent colloid can be 1.41. when the refractive index of the first transparent colloid, the refractive index of the second transparent colloid and the refractive index of the third transparent colloid are alternatively set (i.e. alternating between high and low), the refractive index of the second transparent colloid can be 1.41, the refractive index of the first transparent colloid and the refractive index of the third transparent colloid each can be 1.54; or, the refractive index of the second transparent colloid can be 1.54, and the refractive index of the first transparent colloid and the refractive index of the third transparent colloid each can be 1.41.

In some embodiments, the materials of the first transparent colloid, the second transparent colloid and the third transparent colloid may include but not limited to materials with good transparency such as the silica gel, acrylic and epoxy resin, etc, and the refractive indices of the first transparent colloid, the second transparent colloid and the third transparent colloid may be the same or different by adjusting the ingredients of the silica gel, acrylic and epoxy resin, etc. Optionally, in order to improve light-emitting efficiency, the light transmittances of the first transparent colloid, the second transparent colloid and the third transparent colloid may be limited to be above 95%.

In some embodiments, the above-mentioned display substrate provided by the embodiments of the present disclosure, as shown in FIGS. 5 and 6, further includes a transparent substrate layer 105, the transparent substrate layer 105 is arranged at a side of a stacked layers including the first transparent colloid, the second transparent colloid and the third transparent colloid away from the base substrate 103, so that the stacked layer including the respective transparent colloids can be protected by the transparent substrate layer 105. Optionally, the refractive index of the first transparent colloid, the refractive index of the second transparent colloid, the refractive index of the third transparent colloid and the refractive index of the transparent substrate layer 105 included in a stacked layer can sequentially increase, or sequentially decrease, or are alternatively set in value, so that the transparent substrate layer 105 is matched with the stacked layer including the respective transparent colloids to further enhance the effect of light mixing and improve the color shift.

In some embodiments, the material of the transparent substrate layer 105 can be polyethylene terephthalate (PET) or polycarbonate (PC). The refractive index of PET is 1.61, and the refractive index of PC is 1.51. Relevant data shows that in products with the transparent substrate layer 105 made of PET, the color shift at viewing angle is (H0.019, V0.034), and the brightness of the black state is 0.048 nit; and in products with the transparent substrate layer 105 made of PC, the color shift at viewing angle is (H0.019, V0.023), and the brightness of the black state is 0.044nit. It can be seen that the products with the transparent substrate layer 105 made of PC has the better color shift at viewing angle and contrast than the products with the transparent substrate layer 105 made of PET.

In some embodiments, the above-mentioned display substrate provided by the embodiments of the present disclosure, as shown in FIGS. 5 and 6, may further include at least one auxiliary function layer (e.g., including an anti-fingerprint layer 107 and a hardened layer 106) located at a side of the transparent substrate layer 105 away from the base substrate 103. The refractive index of the first transparent colloid, the refractive index of the second transparent colloid, the refractive index of the third transparent colloid, the refractive index of the transparent substrate layer 105, and the refractive index of one or more auxiliary functional layers sequentially increase, or sequentially decrease, or are alternatively set. For example, when the auxiliary function layer includes the hardened layer 106 and the anti-fingerprint layer 107 and the hardened layer 106 is located between the transparent substrate layer 105 and the anti-fingerprint layer 107, the refractive index of the first transparent colloid, the refractive index of the second transparent colloid, the refractive index of the third transparent colloid, the refractive index of the transparent substrate layer 105, the refractive index of the hardened layer 106, and the refractive index of the anti-fingerprint layer 107 included in a stacked layer can be sequentially increase, or sequentially decrease, or are alternatively set, so that the anti-fingerprint layer 107, the hardened layer 106 and the transparent substrate layer 105 as well as the respective transparent colloid layers are matched with one another to further enhance the effect of light mixing and improve the color shift. In addition, the anti-fingerprint layer 107 and the hardened layer 106 can also increase the anti-fingerprint and scratch resistance of the product.

In some embodiments, as shown in FIG. 1 and FIG. 3, the encapsulating structure may include the above-mentioned transparent substrate layer 105. In order to protect the encapsulating layer(s) and the transparent substrate layer 105 during handling and the like, a release film 100 can be provided on the side where the first encapsulating layer 101 is located, and a protective film 108 is provided on the side where the transparent substrate layer 105 is located. In the specific implementation, after the release film 100 is peeled off, the first encapsulating layer 101 can be laminated with the display substrate; and after the protective film 108 is peeled off, the anti-fingerprint layer 107 and the hardened layer 106 can be made on the transparent substrate layer 105.

In some embodiments, in the above display substrate provided by the embodiments of the present disclosure, the hardened layer 106 and/or the anti-fingerprint layer 107 may include atomized particles. The atomized particles can make the anti-fingerprint layer 107 and the hardened layer 106 present a fog effect. In addition, it is worth noted that, in the case that the anti-fingerprint layer 107 and the hardened layer 106 are not doped with atomized particles, the anti-fingerprint layer 107 and the hardened layer 106 can exhibit a mirror effect. In some embodiments, the material of the atomized particles may be the silicon dioxide (SiO₂) or polymethyl methacrylate (PMMA).

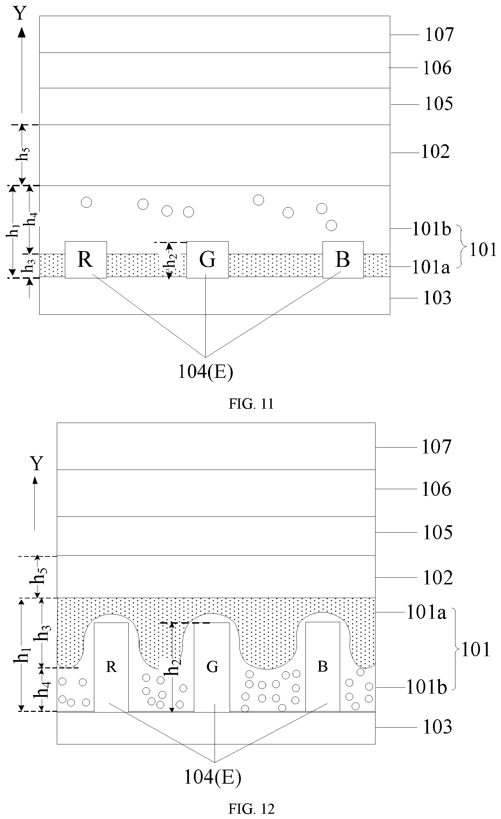

In some embodiments, in the above-mentioned display substrate provided by the embodiments of the present disclosure, as shown in FIGS. 11 and 12, at least one of the second transparent colloid contained in the second encapsulating sub-layer 101b and the third transparent colloid contained in the second encapsulating layer 102 is dispersed with diffusion particles, so as to further improve the effect of light mixing and improve color shift through the scattering for the light by the diffusion particles.

It can be seen from FIGS. 11 and 12 that the second encapsulating sub-layer 101b directly wraps each light-emitting device 104. In order to achieve the better effect of light mixing, in the above-mentioned display substrate provided by the embodiments of the present disclosure, the second transparent colloid of the second encapsulating sub-layer 101b can be preferably dispersed with diffusion particles. In some embodiments, the first encapsulating sub-layer 101a appears black because it is doped with carbon black particles, the second encapsulating sub-layer 101b appears white because it is doped with diffusion particles (e.g., white particles), and the second encapsulating layer 102 appears transparent due to no doped diffusion particles.

It is worth noted that, as can be seen from FIG. 11, compared with the second encapsulating sub-layer 101b and the second encapsulating layer 102, the black first encapsulating sub-layer 101a is located at the bottom layer closest to the base substrate 103. It can be seen from FIG. 12, compared with the second encapsulating sub-layer 101b and the second encapsulating layer 102, the black first encapsulating sub-layer 101a is located at the middle layer except the top layer farthest from the base substrate 103 and the bottom layer closest to the base substrate 103. Therefore, when the product is in a dark state, in FIG. 12, the black first encapsulating sub-layer 101a can effectively absorb the ambient light, which is prevented from irradiating on the diffusion particles in the lower second encapsulating sub-layer 101b and being scattered. In FIG. 11, part of the ambient light can irradiate the diffusion particles in the second encapsulating sub-layer 101b and be scattered, and the rest of the ambient light can pass through the second encapsulating sub-layer 101b and irradiate to the black first encapsulating sub-layer 101a to be absorbed. Since the black first encapsulating sub-layer 101a can absorb the ambient light to increase the contrast, and the diffusion particles can scatter the ambient light to reduce the contrast, the effect of improving the contrast in FIG. 11 is better than that in FIG. 12.

In some embodiments, in the above display substrate provided by the embodiments of the present disclosure, the particle size of the diffusion particles may be in a micron-scale or nano-scale. Considering that the diffusion particles can affect the light transmittance to a certain extent while diffusing the light, the concentration of the diffusion particles needs to be set reasonably. Optionally, on the basis of taking into account both the light mixing and transmittance, the mass fraction (i.e., concentration) of the micron-scale diffusion particles in the second transparent colloid can be set to be in a range of 10%-15%. The nano-scale diffusion particles have a greater impact on the transmittance, therefore, the mass fraction of nano-scale diffusion particles in the second transparent colloid can be smaller than the mass fraction of micron-scale diffusion particles in the second transparent colloid. For example, the mass fraction of the nano-scale diffusion particles in the second transparent colloid is set to be in a range of 1.5%-3.5%.

In some embodiments, in the above-mentioned display substrate provided by the embodiments of the present disclosure, the diffusion particles may be transparent particles or white particles. It should be understood that, when the diffusion particles are the transparent particles, the second encapsulating layer 101b is colorless and transparent; and when the diffusion particles are the white particles, the second encapsulating sub-layer 101b with the diffusion particles is white. The second encapsulating sub-layer 101b in a transparent or white state can have better transmittance, which is beneficial to improve the light efficiency.

In some embodiments, in the above-mentioned display substrate provided by the embodiments of the present disclosure, the material of the transparent particles may include atomized particles, e.g., the silicon dioxide (SiO₂) or polymethyl methacrylate (PMMA), etc. The material of the white particles includes the titanium dioxide (TiO₂). Certainly, in the specific implementation, the materials of the transparent particles and the white particles may also be other materials known to those skilled in the art, which are not specifically limited herein.

It should be noted that those of ordinary skill in the art should understand that the above-mentioned display substrate provided by the embodiments of the present disclosure has other essential components (e.g., a driving circuit), which will not be repeated herein and should not as a limitation of the disclosure.

Based on the same inventive concept, embodiments of the present disclosure also provide a manufacturing method for the above-mentioned display substrate. Since the problem-solving principle of the manufacturing method is similar to that of the above-mentioned display substrate, the implementation of the manufacturing method can refer to the above-mentioned embodiment of the display substrate, which will not be repeated herein.

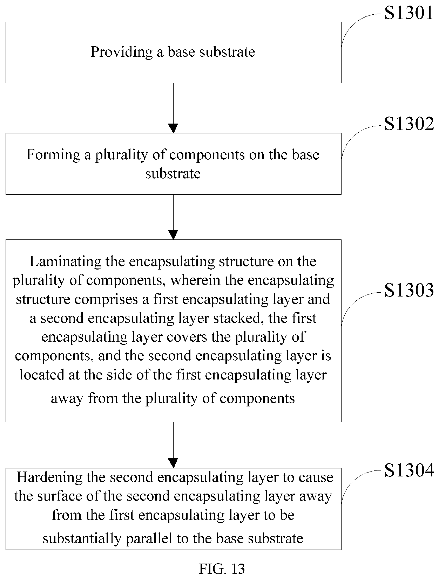

Specifically, the manufacturing method for the above-mentioned display substrate provided by the embodiments of the present disclosure, as shown in FIG. 13, may include the following steps.

S1301, providing a base substrate.

S 1302, forming a plurality of components on the base substrate.

S1303, laminating an encapsulating structure on the plurality of components; the encapsulating structure includes a first encapsulating layer and a second encapsulating layer stacked, the first encapsulating layer covers the plurality of components, and the second encapsulating layer is located at a side of the first encapsulating layer away from the plurality of components.

S1304, hardening (e.g., heating or light irradiating) the second encapsulating layer, so that the surface of the second encapsulating layer away from the first encapsulating layer is substantially parallel to the base substrate. Optionally, the hardness of the second encapsulating layer is greater than that of the first encapsulating layer.

It should be noted that, in the above manufacturing method provided by the embodiments of the present disclosure, the patterning process involved in forming each layer structure may not only include a part or all of processes of the deposition, photoresist coating, masking using a mask, exposure, development, etching, photoresist stripping, etc., but also include other processes, which are specific to the required pattern in the actual manufacture process and is not limited herein. For example, a post-baking process may also be included after the development and before the etching.

The deposition process can be the chemical vapor deposition, plasma enhanced chemical vapor deposition or physical vapor deposition, which is not limited herein. The mask used in the masking process can be a half tone mask, or single slit mask or gray tone mask, which is not limited herein. The etching can be the dry etching or wet etching, which is not limited herein.

Based on the same inventive concept, an embodiment of the present disclosure further provides a display apparatus, including the above-mentioned display substrate provided by the embodiments of the present disclosure. Since the problem-solving principle of the display apparatus is similar to the problem-solving principle of the above-mentioned display substrate, the implementation of the display apparatus can refer to the above-mentioned embodiment of the display substrate, which will not be repeated herein.

In some embodiments, the display apparatus can be any product or assembly unit with a display function, e.g., a mobile phone, a tablet computer, a television, a display, a notebook computer, a digital photo frame, a navigator, a smart watch, a fitness wristband, a personal digital assistant, etc. The display apparatus includes but not limited to elements, e.g., a radio frequency unit, a network module, an audio output & input unit, a sensor, a display unit, a user input unit, an interface unit, a memory, a processor, and a power supply, etc. In addition, those skilled in the art can understand that the above-mentioned structures do not constitute a limitation on the above-mentioned display apparatus provided by the embodiments of the present disclosure. In other words, the above-mentioned display apparatus provided by the embodiments of the present disclosure may include more or less than the above elements, or a combination of certain elements, or a different arrangement of elements.

Obviously, those skilled in the art can make various changes and modifications to the present disclosure without departing from the spirit and scope of the present disclosure. Thus, if these modifications and variations of the present disclosure fall within the scope of the claims of the present disclosure and equivalent technologies thereof, the present disclosure also intends to include these modifications and variations.

## Claims

1. An encapsulating structure for encapsulating components, comprising:
a first encapsulating layer, configured to cover the components; and
a second encapsulating layer, stacked with the first encapsulating layer, wherein the second encapsulating layer is located at a side of the first encapsulating layer away from the components, a surface of the second encapsulating layer facing the first encapsulating layer is in contact with a surface of the first encapsulating layer facing the second encapsulating layer, and a surface of the second encapsulating layer away from the first encapsulating layer is substantially parallel to a plane where the encapsulating structure is located.

2. The encapsulating structure according to claim 1, wherein the first encapsulating layer comprises at least two encapsulating sub-layers stacked in a direction away from the components, wherein, in the direction away from the components, an encapsulating sub-layer closest to the components comprises an ingredient with variable viscosity.

3. The encapsulating structure according to claim 2, wherein: in the direction away from the components, the encapsulating sub-layer closest to the components further comprises a first transparent colloid, and the ingredient with variable viscosity comprises an adhesive.

4. The encapsulating structure according to claim 3, wherein a mass ratio of the adhesive to the first transparent colloid is greater than or equal to 1:2 and less than or equal to 2:1.

5. The encapsulating structure according to claim 2, wherein: in the direction away from the components, the encapsulating sub-layer closest to the components further comprises a first transparent colloid, and the ingredient with variable viscosity comprises expansion particles.

6. The encapsulating structure according to claim 5, wherein a mass fraction of the expansion particles in the first transparent colloid is greater than or equal to 0.5% and less than or equal to 3%.

7. A display substrate, comprising:
a base substrate;
a plurality of components, located at a side of the base substrate; and
the encapsulating structure according to any one of claims 1-6, wherein the first encapsulating layer covers the plurality of components, and in a direction perpendicular to the base substrate, a thickness of the first encapsulating layer is greater than or equal to a height of the components; and the second encapsulating layer is located at a side of the first encapsulating layer away from the plurality of components, a surface of the second encapsulating layer facing the first encapsulating layer is in contact with a surface of the first encapsulating layer facing the second encapsulating layer, and a surface of the second encapsulating layer away from the first encapsulating layer is substantially parallel to the base substrate.

8. The display substrate according to claim 7, wherein a hardness of the second encapsulating layer is greater than a hardness of the first encapsulating layer.

9. The display substrate according to claim 7, wherein the first encapsulating layer comprises a first encapsulating sub-layer and a second encapsulating sub-layer stacked.

10. The display substrate according to claim 9, wherein at least one of the first encapsulating sub-layer, the second encapsulating sub-layer and the second encapsulating layer comprises diffusion particles and/or carbon black particles.

11. The display substrate according to claim 10, wherein the second encapsulating sub-layer is located at a side of the components away from the first encapsulating sub-layer, and the first encapsulating sub-layer comprises the diffusion particles.

12. The display substrate according to claim 11, wherein the second encapsulating sub-layer comprises the carbon black particles.

13. The display substrate according to claim 12, wherein at least part of the first encapsulating sub-layer and the second encapsulating sub-layer protrudes toward a direction away from light-emitting devices, and an orthographic projection of the protrusions on the base substrate overlaps with an orthographic projection of the light-emitting devices on the base substrate.

14. The display substrate according to claim 13, wherein the protrusions comprise first protrusions located at the first encapsulating sub-layer; and
the orthographic projection of the light-emitting devices on the base substrate is located within an orthographic projection of the first protrusions on the base substrate.

15. The display substrate according to claim 13, wherein the protrusions comprise first protrusions located at the first encapsulating sub-layer, and the first protrusions surround surfaces, perpendicular to the base substrate, of the light-emitting devices, respectively.

16. The display substrate according to claim 14 or 15, wherein a portion of the first encapsulating sub-layer located between first protrusions adjacent to each other is substantially parallel to the base substrate.

17. The display substrate according to any one of claims 14-16, wherein the protrusions comprise second protrusions located at the second encapsulating sub-layer; and
the orthographic projection of the first protrusions on the base substrate is located within an orthographic projection of the second protrusions on the base substrate, and the orthographic projection of the light-emitting devices on the base substrate is located within the orthographic projection of the second protrusions on the base substrate.

18. The display substrate according to claim 17, wherein a portion of the second encapsulating sub-layer located between second protrusions adjacent to each other is substantially parallel to the base substrate.

19. The display substrate according to any one of claims 9-18, wherein the first encapsulating sub-layer comprises a first transparent colloid, the second encapsulating sub-layer comprises a second transparent colloid, and the second encapsulating layer comprises a third transparent colloid; and
a refractive index of the first transparent colloid, a refractive index of the second transparent colloid and a refractive index of the third transparent colloid are substantially equal.

20. The display substrate according to claim 9, wherein the first encapsulating sub-layer comprises a first transparent colloid, the second encapsulating sub-layer comprises a second transparent colloid, and the second encapsulating layer comprises a third transparent colloid; and
a refractive index of the second transparent colloid is different from a refractive index of the first transparent colloid, and the refractive index of the second transparent colloid is different from a refractive index of the third transparent colloid.

21. The display substrate according to claim 20, wherein a color of the first encapsulating sub-layer is black, and a color of the second encapsulating sub-layer is different from the color of the first encapsulating sub-layer.

22. The display substrate according to claim 21, wherein a color of the second encapsulating layer is different from the color of the first encapsulating sub-layer.

23. The display substrate according to claim 22, wherein: in a direction in which the light-emitting devices are away from the base substrate, a sum of a thickness of the first encapsulating sub-layer, a thickness of the second encapsulating sub-layer, and a thicknesses of the second encapsulating layer is greater than a height of the light-emitting devices.

24. The display substrate according to claim 23, wherein an orthographic projection of at least one of the first encapsulating sub-layer, the second encapsulating sub-layer, and the second encapsulating layer in any direction covers an orthographic projection of the light-emitting devices.

25. The display substrate according to claim 24, wherein: in a direction in which light-emitting diodes are away from the base substrate, the first encapsulating sub-layer, the second encapsulating sub-layer and the second encapsulating layer are sequentially stacked;
an orthographic projection of the second encapsulating sub-layer on the base substrate completely covers an orthographic projection of the light-emitting devices on the base substrate and an orthographic projection of a gap between every two adjacent light-emitting devices on the base substrate; and
an orthographic projection of the second encapsulating sub-layer on a plane perpendicular to a surface of the base substrate facing the light-emitting devices partially covers an orthographic projection of the light-emitting devices on the plane perpendicular to the surface of the base substrate facing the light-emitting devices.

26. The display substrate according to claim 25, wherein the first encapsulating sub-layer is located between every two adjacent light-emitting devices; or, an orthographic projection of the first encapsulating sub-layer on the base substrate completely covers the orthographic projection of the light-emitting devices on the base substrate and the orthographic projection of the gap between every two adjacent light-emitting devices on the base substrate; and
an orthographic projection of the first encapsulating sub-layer on the plane perpendicular to the surface of the base substrate facing the light-emitting devices completely covers the orthographic projection of the light-emitting devices on the plane perpendicular to the surface of the base substrate facing the light-emitting devices.

27. The display substrate according to claim 24, wherein: in the direction in which the light-emitting devices are away from the base substrate, the second encapsulating sub-layer, the first encapsulating sub-layer and the second encapsulating layer are sequentially stacked;
an orthographic projection of the first encapsulating sub-layer on the base substrate completely covers an orthographic projection of the light-emitting devices on the base substrate and an orthographic projection of a gap between every two adjacent light-emitting devices on the base substrate;
an orthographic projection of the first encapsulating sub-layer on a plane perpendicular to a surface of the base substrate facing the light-emitting devices partially covers an orthographic projection of the light-emitting devices on the plane perpendicular to the surface of the base substrate facing the light-emitting devices;
an orthographic projection of the second encapsulating sub-layer on the base substrate completely covers the orthographic projection of the light-emitting devices on the base substrate and the orthographic projection of the gap between every two adjacent light-emitting devices on the base substrate; and
an orthographic projection of the second encapsulating sub-layer on the plane perpendicular to the surface of the base substrate facing the light-emitting devices completely covers the orthographic projection of the light-emitting devices on the plane perpendicular to the surface of the base substrate facing the light-emitting devices.

28. The display substrate according to any one of claims 25-27, wherein a surface of the second encapsulating sub-layer away from the base substrate is substantially parallel to the base substrate.

29. The display substrate according to any one of claims 25-27, wherein a surface of the second encapsulating sub-layer away from the base substrate at the gap between every two adjacent light-emitting devices is substantially parallel to the base substrate, and protrudes, at a region where the light-emitting devices are located, toward the direction in which the light-emitting devices are away from the base substrate.

30. The display substrate according to any one of claims 18-29, wherein a refractive index of the first transparent colloid, a refractive index of the second transparent colloid and a refractive index of the third transparent colloid sequentially increase, or sequentially decrease, or are alternatively set.

31. The display substrate according to claim 30, wherein a maximum refractive index among the refractive index of the first transparent colloid, the refractive index of the second transparent colloid and the refractive index of the third transparent colloid is greater than or equal to 1.6, and a minimum refractive index among the refractive index of the first transparent colloid, the refractive index of the second transparent colloid and the refractive index of the third transparent colloid is approximately 1.41.

32. The display substrate according to claim 30 or 31, further comprising: a transparent substrate layer located at a side of a stacked layer comprising the first transparent colloid, the second transparent colloid and the third transparent colloid away from the base substrate; and
the refractive index of the first transparent colloid, the refractive index of the second transparent colloid, the refractive index of the third transparent colloid and a refractive index of the transparent substrate layer comprised in a stacked layer sequentially increase, or sequentially decrease, or are alternatively set in value.

33. The display substrate according to claim 32, further comprising at least one auxiliary function layer located at a side of the transparent substrate layer away from the base substrate;
wherein the refractive index of the first transparent colloid, the refractive index of the second transparent colloid, the refractive index of the third transparent colloid, and a refractive index of the at least one auxiliary function layer sequentially increase, or sequentially decrease, or are alternatively set.

34. The display substrate according to claim 33, wherein the at least one auxiliary function layer comprises: a hardened layer and an anti-fingerprint layer stacked, and the hardened layer is located between the transparent substrate layer and the anti-fingerprint layer.

35. The display substrate according to claim 34, wherein the anti-fingerprint layer and/or the hardened layer comprise atomized particles.

36. The display substrate according to any one of claims 21-33, wherein at least one of the second transparent colloid and the third transparent colloid is dispersed with diffusion particles.

37. The display substrate according to claim 36, wherein the second transparent colloid is dispersed with diffusion particles.

38. The display substrate according to claim 37, wherein a particle size of the diffusion particles is in a micron-scale, and a mass fraction of the diffusion particles in the second transparent colloid is in a range of 10%-15%.

39. The display substrate according to claim 37, wherein a particle size of the diffusion particles is in a nano-scale, and a mass fraction of the diffusion particles in the second transparent colloid is in a range of 1.5%-3.5%.

40. The display substrate according to any one of claims 37-39, wherein the diffusion particles are transparent particles or white particles.

41. The display substrate according to claim 40, wherein a material of the transparent particles comprises silicon dioxide or polymethyl methacrylate, and a material of the white particles comprises titanium dioxide.

42. The display substrate according to any one of claims 21-41, wherein the first encapsulating sub-layer is black, the second encapsulating sub-layer is white, and the second encapsulating layer is transparent.

43. The display substrate according to any one of claims 21-42, wherein the first encapsulating sub-layer comprises carbon black particles dispersed in the first transparent colloid.

44. The display substrate according to any one of claims 7-43, wherein the components are light-emitting devices.

45. A manufacturing method for a display substrate, wherein the display substrate is according to any one of claims 7-44, and the method comprises:
providing a base substrate;
forming a plurality of components on the base substrate;
laminating the encapsulating structure on the plurality of components, wherein the encapsulating structure comprises a first encapsulating layer and a second encapsulating layer stacked, the first encapsulating layer covers the plurality of components, and the second encapsulating layer is located at the side of the first encapsulating layer away from the plurality of components; and
hardening the second encapsulating layer to cause the surface of the second encapsulating layer away from the first encapsulating layer to be substantially parallel to the base substrate.

46. A display apparatus, comprising the display substrate according to any one of claims 7-44.
